# FASCICULE DE BREVET EUROPEEN

(11) **EP 3 966 519 B1**
(45) Date de publication et mention de la délivrance du brevet: **07.06.2023**
(21) Numéro de dépôt: 20723419.6
(22) Date de dépôt: 07.05.2020
(51) Int. Cl.: G01B 7/16

(54) **CAPTEUR MEMS DE DÉFORMATION PAR RUPTURE DE CONTACT ENTRE DEUX ÉLECTRODES**
MEMS-SENSOR ZUR MESSUNG DER VERFORMUNG DURCH BRECHEN DES KONTAKTES ZWISCHEN ZWEI ELEKTRODEN
MEMS SENSOR FOR SENSING DEFORMATION BY BREAKING CONTACT BETWEEN TWO ELECTRODES

(30) Priorité: 10.05.2019 FR 1904884
(43) Date de publication de la demande: 16.03.2022
(73) Titulaire: Silmach, 25000 Besançon (FR)
(72) Inventeur: SWOROWSKI, Marc, 14000 CAEN (FR); HAYE, Charles, 25870 DEVECEY (FR)
(74) Mandataire: Regimbeau
(86) Numéro de dépôt international: PCT/EP2020/062733
(87) Numéro de publication internationale: WO 2020/229303

(56) Documents cités:
- WO-A2-2007/045997
- DE-C1- 19 616 506
- FR-A1- 2 418 441
- FR-A1- 2 703 768
- FR-A1- 2 728 677

## Description

La présente invention s'inscrit dans le domaine technique des micro-capteurs de type MEMS (pour « Micro Electro-Mechanical Systems », selon le sigle anglo-saxon couramment utilisé). L'invention concerne plus particulièrement un capteur de déformation de type MEMS et un circuit électronique intégrant un tel capteur.

### ETAT DE LA TECHNIQUE

De nombreux systèmes électroniques intègrent des micro-capteurs MEMS pour la détection en temps réel de déplacements selon une ou plusieurs directions. A titre d'exemple, des capteurs de choc peuvent être intégrés à un système destiné à être soumis à des vibrations au cours de son utilisation, pour mesurer un déplacement dépassant un seuil. Un capteur de type MEMS permet la détection d'un déplacement du système à l'échelle microscopique, et est donc capable de signaler un choc invisible à l'œil nu.

Plusieurs capteurs de déformation MEMS existants comprennent deux éléments mécaniques, l'un des deux éléments étant configuré pour se translater par rapport à l'autre élément et à solliciter mécaniquement ce dernier en cas de déplacement du système dans une direction donnée.

A titre d'exemple, la demande internationale publiée sous le numéro WO 2017/149211 A1 décrit un capteur comprenant une partie de poussée mobile par rapport à un ensemble de détection, l'ensemble de détection comprenant une poutre d'actionnement située sur la course de la partie de poussée. En cas de déplacement du support de la partie de poussée selon une direction de mesure dans le sens d'un rapprochement avec la poutre d'actionnement, la partie de poussée déforme le parallélogramme formé par la poutre d'actionnement et par des poutres de liaison de l'ensemble de détection, et la poutre d'actionnement est déplacée en direction d'une dent fixe située en regard.

Dans ce capteur MEMS de l'art antérieur, l'événement local permettant la détection de déformation est le rapprochement mécanique de la poutre d'actionnement par rapport à la dent fixe en regard.

On connaît d'autres capteurs de déformation MEMS de type actif fonctionnant sous alimentation électrique, dans lesquels une déformation est détectée lorsqu'un contact électrique est établi entre des éléments déformables peu distants portés à des potentiels différents.

Selon un exemple, lesdits éléments déformables sont des poutres déformables parallèles peu écartées axialement l'une de l'autre. Une partie de poussée, mobile selon une direction sensiblement perpendiculaire aux deux poutres au repos, est positionnée en regard des deux poutres.

Lorsque le capteur est alimenté en énergie électrique, les deux poutres sont placées à des potentiels électriques différents. Quand le support de la partie de poussée subit un déplacement dans la direction de mobilité de la partie de poussée sur une distance supérieure ou égale à une distance de seuil, la partie de poussée entraîne l'une des deux poutres contre l'autre poutre. Les deux poutres sont alors en contact mécanique ; si la pression exercée par la partie de poussée au niveau de la zone de contact est suffisante, une tension électrique est établie entre les deux poutres.

Un inconvénient de ce type de capteurs de déformation actifs est qu'il existe une plage d'incertitude sur la distance de déplacement de la partie de poussée à partir de laquelle le contact électrique est établi entre les deux poutres. L'écart entre les deux poutres, selon la direction de mobilité de la partie de poussée, est dimensionné de sorte que le contact mécanique soit créé précisément à partir de la distance de seuil. Cependant, les poutres sont flexibles et présentent une déformabilité selon la direction de mobilité de la partie de poussée. Ainsi, la partie de poussée peut se déplacer d'une distance supérieure au seuil en cas de déformation, les deux poutres rentrant ainsi en contact mécanique, sans pour autant que la force de pression d'une poutre contre l'autre ne soit suffisante pour générer un contact électrique à faible résistance.

Dans ce dernier cas, le rapprochement des deux poutres n'est détecté que pour une certaine distance de déplacement de la partie de poussée strictement supérieure à la distance de seuil. Un déplacement de la partie de poussée sur une distance égale ou à peine supérieure à la distance de seuil peut ne pas être détecté. La détection de déformation est donc entachée d'une imprécision qui n'est pas acceptable pour certaines applications.

La plage d'incertitude sur la distance de déplacement de la partie de poussée peut être réduite en augmentant la rigidité des poutres dans la direction de mobilité de la partie de poussée. Toutefois, il reste nécessaire que les poutres déformables demeurent suffisamment flexibles dans la direction de mobilité pour autoriser un déplacement ultérieur de la partie de poussée dans le sens de rapprochement des deux poutres, après mise en contact mécanique des deux poutres.

D'autres capteurs de déformation de type MEMS sont décrits par FR 2 418 441 A1 et FR 2 728 677 A1.

### DESCRIPTION GENERALE DE L'INVENTION

Il existe donc un besoin pour un capteur de déformation MEMS fonctionnant par détection d'un changement de résistance électrique au niveau d'électrodes mobiles, dont la précision de détection soit améliorée.

Notamment, le changement de résistance électrique entre les éléments mobiles doit correspondre très précisément au dépassement d'un seuil de déformation prédéterminé.

Il existe un besoin additionnel pour un capteur de déformation MEMS compatible avec une alimentation électrique intermittente. La détection d'un événement de dépassement du seuil de déformation ne doit pas être compromise par une absence ou une coupure d'alimentation électrique dans le capteur.

On recherche, de manière secondaire et pour certaines applications spécifiques, un capteur de déformation MEMS qui permette une telle mémorisation de type mécanique d'un événement de dépassement du seuil de déformation, tout en étant réutilisable pour détecter des événements de déformation ultérieurs. Pour d'autres applications spécifiques, on recherche un capteur de déformation configuré pour adopter de manière définitive une position déplacée après un événement de dépassement du seuil, le capteur étant alors infalsifiable.

Pour répondre à ces besoins, l'invention concerne, selon un premier aspect, un capteur de déformation de type MEMS, le capteur étant adapté pour mesurer un déplacement relatif entre deux zones d'une structure, le capteur comprenant :
- une première partie et une deuxième partie étant mobiles l'une par rapport à l'autre selon une direction de mesure,
- un élément de poussée monté fixe par rapport à la première partie,
- une première électrode et une deuxième électrode étant adaptées pour être portées à des potentiels électriques différents, chaque électrode étant montée fixe par rapport à la deuxième partie,
- une partie de raccordement formant une liaison électrique entre la première électrode et la deuxième électrode,
l'élément de poussée étant configuré pour exercer une sollicitation sur la partie de raccordement lorsque la première partie se déplace par rapport à la deuxième partie selon la direction de mesure au-delà d'une distance prédéterminée, la liaison électrique étant rompue sous l'effet de la sollicitation.

Avec le capteur de déformation MEMS de l'invention, le dépassement d'un seuil prédéterminé de déformation - correspondant à un déplacement de la première partie portant l'élément de poussée par rapport à la deuxième partie au-delà de la distance prédéterminée - est détecté grâce à la rupture de la liaison électrique entre les deux électrodes. La rupture de cette liaison électrique peut être détectée par un système de mesure ultérieurement à l'événement de déformation, lors d'une interrogation de l'état du capteur par un système distant. En alternative, la rupture de la liaison électrique peut être détectée en temps réel par le système de mesure configuré pour transmettre cette information au système distant. Un tel système de mesure peut être un microcontrôleur mesurant un potentiel électrique au niveau de l'une des deux électrodes.

Il n'est pas nécessaire que la partie de raccordement soit déformable au niveau de sa zone de contact avec l'élément de poussée, contrairement aux capteurs de l'état de la technique fonctionnant par mise en contact électrique des électrodes lors de l'événement de déformation. Ainsi, lorsque la partie de raccordement est sollicitée par l'élément de poussée, la liaison électrique est rompue de manière nette. La rupture de la liaison électrique correspond plus précisément à la distance de déplacement prédéterminée de l'élément de poussée pour laquelle le capteur a été dimensionné, par rapport aux capteurs MEMS de l'art antérieur où la rupture de la liaison électrique peut survenir pour une distance de déplacement éloignée de la valeur pour laquelle le capteur a été dimensionné.

La détection de dépassement du seuil de déformation par rupture de la liaison électrique, provoquée par la poussée contre la partie de raccordement électrique, présente donc l'avantage de minimiser la plage d'incertitude autour du seuil de déformation. Le capteur de déformation de l'invention présente ainsi une meilleure précision de détection.

Un autre avantage du capteur de l'invention est de ne pas nécessairement empêcher un déplacement ultérieur de l'élément de poussée, selon la direction de mesure et dans le même sens de mesure, au-delà de la distance de déplacement prédéterminée. En effet, le capteur de l'invention ne nécessite pas un rapprochement direct de deux électrodes l'une contre l'autre. La course de l'élément de poussée n'est donc pas nécessairement limitée et peut se poursuivre une fois qu'un événement de déformation est survenu.

Le capteur de déformation tel que défini ci-avant peut comprendre en outre les caractéristiques non limitatives suivantes, prises seules ou en l'une quelconque des combinaisons techniquement possibles :
- l'élément de poussée est configuré pour exercer la sollicitation sur la partie de raccordement lorsque la première partie se déplace par rapport à la deuxième partie selon un premier sens, et pour ne pas exercer de sollicitation sur la partie de raccordement lorsque la première partie se déplace par rapport à la deuxième partie dans un deuxième sens, opposé au premier sens, selon la direction de mesure.
- la partie de raccordement comprend un premier pont et un deuxième pont, le premier pont et le deuxième pont étant fixés respectivement à la première électrode et à la deuxième électrode, la sollicitation de l'élément de poussée sur la partie de raccordement ayant pour effet de rompre le premier pont et le deuxième pont.
- dans ce dernier cas, le premier pont et le deuxième pont sont formés par des portions amincies de la partie de raccordement.
- la partie de raccordement comprend un élément déformable, l'élément déformable étant propre à être déformé entre une configuration ouverte et une configuration fermée, la partie de raccordement reliant électriquement la première électrode et la deuxième électrode entre elles lorsque l'élément déformable est dans la configuration fermée, l'élément de poussée étant propre à solliciter l'élément déformable depuis la configuration ouverte vers la configuration fermée lorsque la première partie se déplace par rapport à la deuxième partie selon la direction de mesure.
- dans ce dernier cas, l'élément déformable comporte une première extrémité fixée à la deuxième électrode et une deuxième extrémité propre à être déplacée par rapport à la deuxième électrode lors d'une déformation de l'élément déformable.
- l'élément déformable présente une première rigidité au voisinage de la première extrémité et présente une deuxième rigidité au voisinage de la deuxième extrémité, la première rigidité étant strictement inférieure à la deuxième rigidité.
- le capteur comprend une butée agencée pour autoriser un déplacement relatif de l'élément de poussée dans un premier sens vers l'élément déformable jusqu'à ce que l'élément de poussée sollicite l'élément déformable, et pour empêcher un déplacement ultérieur de l'élément de poussée dans un deuxième sens, opposé au premier sens.
- dans ce dernier cas, le capteur comprend un bras comportant une terminaison, l'élément de poussée comprenant un élément de verrouillage s'étendant depuis la terminaison selon une direction sensiblement parallèle à la direction de mesure, l'élément de verrouillage étant configuré pour coopérer avec la butée.
- la butée fait saillie à partir de la deuxième électrode vers l'élément de poussée.
- la butée comprend une surface de glissement et une surface de blocage, la surface de glissement étant orientée de sorte que lorsque l'élément de poussée se déplace dans un premier sens, vers l'élément déformable, l'élément de poussée glisse sur la surface de glissement, et la surface de blocage étant orientée de sorte que lorsque l'élément de poussée se déplace ultérieurement dans un deuxième sens, opposé au premier sens, en s'écartant de l'élément déformable, l'élément de poussée vient en butée contre la surface de blocage.
- la deuxième partie comprend un substrat de type silicium sur isolant, aussi dit SOI, la première électrode et la deuxième électrode étant portées par le substrat.

L'invention concerne, selon un deuxième aspect, un circuit électronique comprenant un capteur de déformation MEMS tel que défini ci-avant.

De manière avantageuse et non limitative, ledit circuit peut présenter les caractéristiques suivantes prises seules ou en combinaison :
- le circuit comprend en outre un conducteur configuré pour être porté à un potentiel fixe, une résistance comprenant une première borne et une deuxième borne, la première borne étant connectée au conducteur, la deuxième borne étant connectée à la première électrode du capteur de déformation ou à la deuxième électrode du capteur de déformation, et un dispositif de mesure de tension, ledit dispositif étant configuré pour fournir une mesure du potentiel de la deuxième borne.
- le circuit comprend en outre un système de déverrouillage qui comprend un actionneur configuré pour exercer, sur commande, une force apte à repousser l'élément de poussée par rapport à la butée, de préférence une force électrostatique ou magnétique.

Selon un troisième aspect, l'invention se rapporte à un capteur de déformation de type MEMS, le capteur étant adapté pour mesurer un déplacement relatif entre deux zones d'une structure, le capteur comprenant :
- une première partie et une deuxième partie étant mobiles l'une par rapport à l'autre selon une direction de mesure,
- un élément de poussée monté fixe par rapport à la première partie,
- une première électrode et une deuxième électrode étant adaptées pour être portées à des potentiels électriques différents, chaque électrode étant montée fixe par rapport à la deuxième partie,
- une partie de raccordement comprenant un élément déformable, l'élément déformable présentant une position ouverte et une position fermée, la partie de raccordement formant liaison électrique entre la première électrode et la deuxième électrode lorsque l'élément déformable est dans la position fermée, l'élément de poussée étant configuré pour solliciter l'élément déformable depuis l'une des position ouverte ou fermée vers l'autre des positions ouverte ou fermée lorsque la première partie se déplace par rapport à la deuxième partie selon la direction de mesure,
- une butée agencée pour autoriser un déplacement relatif de l'élément de poussée vers l'élément déformable dans un premier sens jusqu'à ce que l'élément de poussée sollicite l'élément déformable, et pour empêcher un déplacement ultérieur de l'élément de poussée dans un deuxième sens, opposé au premier sens.

Le capteur de déformation tel que défini selon ce troisième aspect peut comprendre en outre les caractéristiques non limitatives suivantes, prises seules ou en l'une quelconque des combinaisons techniquement possibles :
- l'élément déformable comporte une première extrémité fixée à la deuxième électrode et une deuxième extrémité propre à être déplacée par rapport à la deuxième électrode lors d'une déformation de l'élément déformable.
- dans ce dernier cas, l'élément déformable présente une première rigidité au voisinage de la première extrémité et présente une deuxième rigidité au voisinage de la deuxième extrémité, la première rigidité étant strictement inférieure à la deuxième rigidité.
- le capteur comprend un bras comportant une terminaison, l'élément de poussée comprenant un élément de verrouillage s'étendant depuis la terminaison selon une direction sensiblement parallèle à la direction de mesure, l'élément de verrouillage étant configuré pour coopérer avec la butée.
- la butée fait saillie à partir de la deuxième électrode en direction de l'élément de verrouillage.
- la butée comprend une surface de glissement et une surface de blocage, la surface de glissement étant orientée de sorte que lorsque l'élément de poussée se déplace dans un premier sens, vers l'élément déformable, l'élément de poussée glisse sur la surface de glissement, et la surface de blocage étant orientée de sorte que lorsque l'élément de poussée se déplace ultérieurement dans un deuxième sens, opposé au premier sens, en s'écartant de l'élément déformable, l'élément de poussée vient en butée contre la surface de blocage.

L'invention concerne, selon un quatrième aspect, un circuit électronique comprenant un capteur de déformation MEMS tel que défini selon le troisième aspect.

Ce circuit peut présenter, de manière avantageuse et non limitative, les caractéristiques suivantes :
- le circuit comprend en outre un conducteur configuré pour être porté à un potentiel fixe, une résistance comprenant une première borne et une deuxième borne, la première borne étant connectée au conducteur, la deuxième borne étant connectée à la première électrode du capteur de déformation ou à la deuxième électrode du capteur de déformation, et un dispositif de mesure de tension, ledit dispositif étant configuré pour fournir une mesure du potentiel de la deuxième borne.
- le circuit comprend en outre un système de déverrouillage qui comprend un actionneur configuré pour exercer, sur commande, une force apte à repousser l'élément de poussée par rapport à la butée, de préférence une force électrostatique ou magnétique.

### DESCRIPTION GENERALE DES FIGURES

D'autres caractéristiques, buts et avantages de l'invention ressortiront de la description qui suit, qui est purement illustrative et non limitative, et qui doit être lue en regard des dessins annexés parmi lesquels :
La **Figure 1a** représente schématiquement un circuit selon un mode de réalisation comprenant un capteur de déformation, les parties mobiles du capteur étant dans une position de repos ;
La **Figure 1b** représente schématiquement le circuit de la Figure 1a, les parties mobiles du capteur étant dans une position de sollicitation de la partie de raccordement, différente de la position de repos ;
La **Figure 2** est un schéma illustrant des éléments d'un capteur de déformation selon une première variante ;
La **Figure 3a** est un schéma illustrant des éléments d'un capteur de déformation selon une deuxième variante ;
La **Figure 3b** est un schéma illustrant des éléments d'un capteur de déformation selon une troisième variante ;
La **Figure 4** est un schéma illustrant des éléments d'un capteur de déformation selon une quatrième variante ;
La **Figure 5** est un schéma de principe d'une mesure au sein d'un circuit électronique comprenant un capteur de déformation.

### DESCRIPTION DETAILLEE DE MODES DE REALISATION

Sur l'ensemble des figures et dans la description détaillée ci-après, les éléments similaires portent des références alphanumériques identiques.

### Circuit intégrant un capteur actif de déformation - Architecture générale

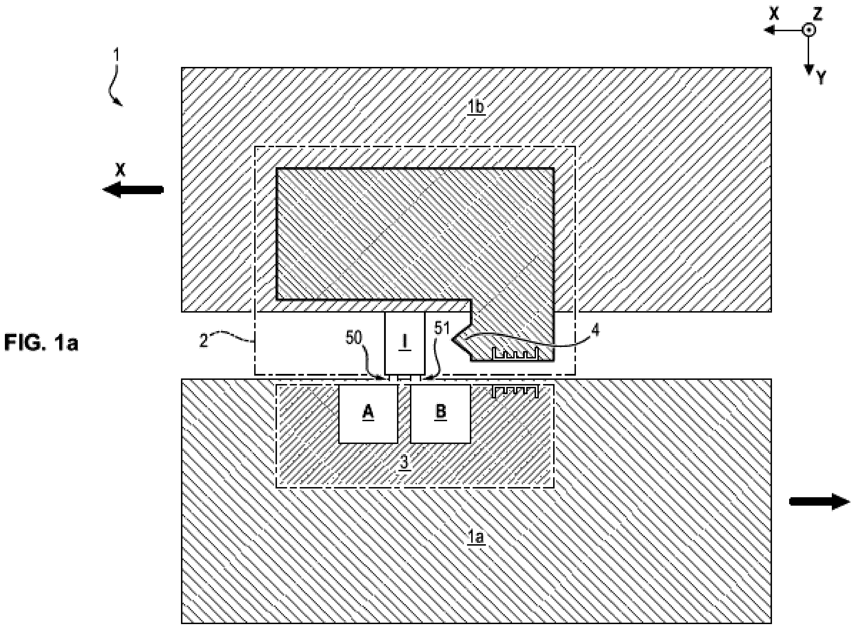

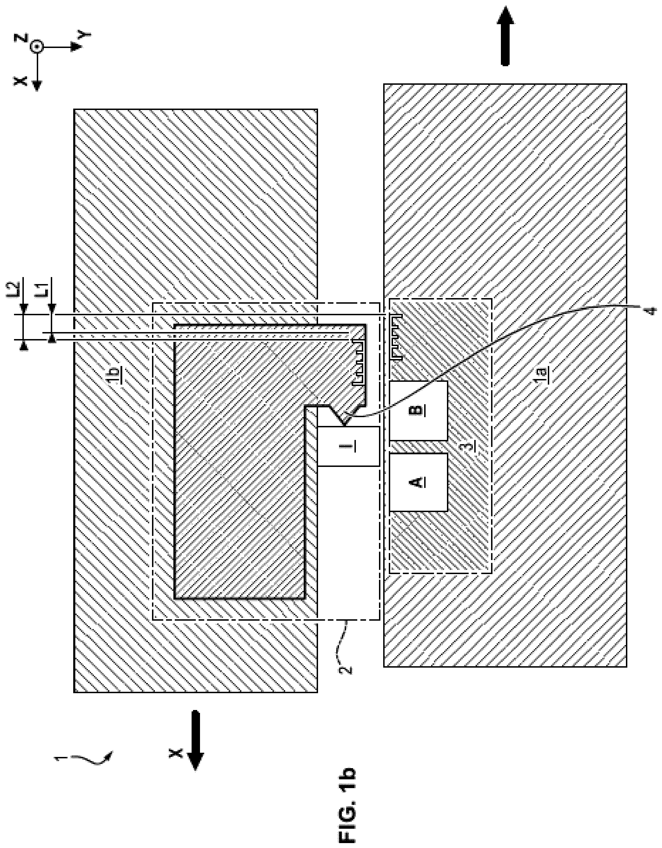

Les Figures 1a et 1b représentent un capteur de type MEMS (pour Micro Electro-Mechanical System) embarqué dans un circuit électronique 1. Le circuit 1 comprend un support mécanique haut 1a et un support mécanique bas 1b. Les Figures 1a et 1b correspondent respectivement à une position de repos et une position de sollicitation d'une partie de raccordement I du capteur.

Le capteur proposé forme un dispositif pour détecter une déformation d'une structure sur laquelle le circuit électronique 1 est embarqué.

On entendra dans la suite par « événement de déformation » une déformation ressentie au niveau du capteur, se traduisant par un déplacement relatif des deux supports 1a et 1b.

On comprendra que les termes « haut » et « bas », pour désigner le support mécanique haut 1a et le support mécanique bas 1b, sont valables pour l'orientation illustrée sur les Figures 1a et 1b. En fonctionnement, les deux supports peuvent être positionnés selon d'autres orientations. On a représenté sur les Figures 1a et 1b un repère tridimensionnel (X, Y, Z) ; le capteur est ici configuré pour détecter une translation du support 1a par rapport au support 1b selon la direction de mesure X, dans le sens d'un déplacement du support 1a vers la gauche par rapport au support 1b.

Les supports mécaniques 1a et 1b servent respectivement de supports pour une première partie mobile 2 et une deuxième partie mobile 3 du capteur. Ainsi, la première partie 2 est solidaire du support 1a et la deuxième partie 3 est solidaire du support 1b. Les parties mobiles 2 et 3 portent les éléments utiles pour la détection de déformation.

Le capteur proposé est un capteur ici MEMS de type actif, destiné à fonctionner avec une alimentation électrique (non représentée) au moment de l'interrogation du capteur. L'alimentation électrique du capteur peut être intermittente, c'est-à-dire qu'il n'est pas nécessaire que le capteur soit alimenté en courant électrique lors de la survenance de l'événement de déformation ; si le capteur est ultérieurement alimenté en énergie électrique, au moment d'interroger le capteur, il sera possible de détecter que l'événement de déformation a eu lieu.

La deuxième partie 3 comporte un substrat sur lequel sont montées les électrodes A et B. Le ou les matériaux du substrat sont choisis avec une rigidité, une cristallinité et une résistivité conformes à une utilisation au sein d'un capteur MEMS. La résistivité du ou des matériaux peut être diminuée avec un traitement de surface spécifique comme une métallisation, par exemple par dépôt d'or. De plus, le substrat doit être compatible avec les procédés usuels de micro-fabrication. De manière préférée, ledit substrat est un substrat de type silicium sur isolant, aussi dit SOI selon le sigle anglo-saxon courant.

De plus, le substrat est réalisé de sorte à permettre une reprise de contact électrique au niveau des électrodes A et B.

La première partie 2 supporte un élément de poussée 4, fixe par rapport à la première partie 2. La deuxième partie 3 comprend deux électrodes A et B destinées à être portées respectivement à un premier potentiel et à un deuxième potentiel lorsque le capteur est alimenté, les deux potentiels étant différents.

La deuxième partie 3 comporte également une partie de raccordement I. Au repos (avant sollicitation par l'élément de poussée 4), la partie de raccordement I est montée fixe par rapport à la deuxième partie 3, notamment en translation selon la direction X, et cette partie de raccordement réalise une liaison électrique entre la première électrode A et la deuxième électrode B. Les électrodes A et B ne présentent de préférence aucune autre liaison électrique entre elles que la partie de raccordement I.

Dans l'exemple de la Figure 1a, la partie de raccordement I comprend un premier pont 50 et un deuxième pont 51. De préférence, la partie de raccordement I est réalisée dans le même matériau que le substrat de la deuxième partie 3, par exemple un matériau de type silicium sur isolant. Le substrat est de faible résistivité ou est rendu conducteur par métallisation. La partie de raccordement est fixée sur la première électrode A par le pont 50 et fixée sur la deuxième électrode B par le pont 51.

Dans l'exemple des Figures 1a et 1b, la première partie 2 comprend une portion s'étendant vers la deuxième partie 3 et ladite portion porte l'élément de poussée 4. L'élément de poussée s'étend selon la direction X, ici en pointe. La partie de raccordement I s'étend en direction de la première partie 2, face à l'élément de poussée 4.

Une séquence de déformation du capteur peut se dérouler comme suit.

Dans la position de repos de la **Figure 1a****,** par exemple à l'état non sollicité d'une structure comprenant le capteur, l'élément de poussée 4 est situé à distance de la partie de raccordement I.

Selon une première possibilité, le capteur n'est pas alimenté en énergie électrique lors de l'événement de déformation au cours de la séquence décrite ci-après. En effet, comme il sera vu dans la suite, le capteur MEMS proposé présente l'avantage de permettre la détection d'un événement de déformation dépassant un seuil prédéterminé, même si cet événement se produit en l'absence d'alimentation électrique du capteur. Lors d'une interrogation ultérieure de l'état du capteur par un système distant, le capteur est en revanche alimenté en énergie électrique afin de permettre une mesure par un système de mesure, et les deux électrodes A et B sont portées à des potentiels différents. L'interrogation ultérieure du capteur permet de constater *a posteriori* la survenance d'un événement de déformation.

Selon une deuxième possibilité, le capteur est alimenté en énergie électrique lors de l'événement de déformation au cours de la séquence décrite ci-après.

Lors d'une sollicitation mécanique du capteur, par exemple en cas de choc ou d'événement vibratoire subi par le capteur, la première partie 2 peut se déplacer par rapport à la deuxième partie 3 selon la direction de mesure X, dans le sens d'un rapprochement de l'élément de poussée 4 et de la partie de raccordement I.

La partie de raccordement I suit ainsi la deuxième partie 3 au début du mouvement de rapprochement, jusqu'à une distance de déplacement relatif selon la direction X inférieure à la distance identifiée sur la **Figure 1b** par la référence L1. La distance de déplacement L1 est de préférence comprise entre 5 et 500 micromètres, et de manière encore plus préférentielle entre 10 et 200 micromètres.

Si le déplacement relatif se poursuit au-delà de la distance de déplacement L1, par exemple jusqu'à la distance de déplacement L2 ici, l'élément de poussée 4 exerce une sollicitation sur la partie de raccordement I.

Sous l'effet de la sollicitation, la liaison électrique est rompue au niveau de la partie de raccordement I.

La Figure 1b correspond ainsi à une position de sollicitation de la partie de raccordement.

La distance L1 constitue un seuil de déplacement relatif des parties 2 et 3, au-delà duquel il y a rupture de la liaison électrique entre les électrodes A et B. La rupture électrique est par exemple détectée par l'intermédiaire d'une mesure de potentiel au niveau de l'une des deux électrodes.

La mesure de potentiel au niveau de l'une des deux électrodes permet, comme il sera vu ci-après, de mesurer une résistance équivalente entre les deux électrodes A et B. Une valeur d'impédance associée à cette résistance équivalente diffère en fonction de l'existence ou non d'une liaison électrique entre les électrodes A et B passant par la partie de raccordement I.

Ainsi, grâce au capteur proposé, une déformation dépassant un seuil prédéterminé correspondant à la distance de déplacement L1 peut être détectée en temps réel.

Un avantage de ce capteur est que la plage d'imprécision de la détection de la distance de déplacement L1 est grandement réduite par rapport aux capteurs existants. En d'autres termes, un déplacement relatif égal ou à peine supérieur à la distance L1, pour laquelle le capteur a été calibré, donne bien lieu à la détection d'une rupture de la liaison électrique entre les électrodes A et B. La détection de déformation est donc très précise.

La Demanderesse a observé que pour une distance de déplacement L1 entre 10 et 200 micromètres, la plage d'incertitude autour de la distance L1 pour la rupture de la liaison électrique entre A et B peut être rendue inférieure à plus ou moins 1 micromètre.

Le capteur proposé constitue un système simple pour la détection de déformation. Il ne nécessite que des composants usuels dans le domaine de la microélectronique.

Le capteur peut par exemple être obtenu à partir d'un substrat de type silicium, par exemple un substrat silicium sur isolant, avec une structuration des parties 2 et 3 comprenant la partie de poussée et les électrodes (par exemple par gravure) et une métallisation des pistes conductrices pour obtenir un contact électrique de bonne qualité entre les électrodes A et B. Ces opérations permettent une fabrication de plusieurs capteurs par matrice (ou « wafer »). On obtient alors un rapport prix unitaire / précision très satisfaisant pour la fabrication des capteurs.

On notera que l'élément de poussée 4 est ici configuré pour exercer la sollicitation sur la partie de raccordement I lorsque la première partie se déplace vers la gauche par rapport à la deuxième partie selon la direction X, et pour ne pas exercer de sollicitation sur la partie de raccordement I lorsque la première partie se déplace vers la droite par rapport à la deuxième partie selon la direction X. On obtient donc un capteur configuré pour détecter de manière spécifique un déplacement relatif des supports 1a et 1b dans un sens de rapprochement selon la direction X.

Dans l'exemple spécifique de la Figure 1b, la sollicitation exercée par l'élément de poussée 4 est une force de pression sur la partie de raccordement, suffisante pour provoquer une rupture du premier pont 50 et du deuxième pont 51. Après cette rupture, il n'y a plus de liaison mécanique entre les électrodes et la partie de raccordement, et la partie de raccordement n'est plus fixée à la deuxième partie 3.

La plage d'imprécision de la détection de déplacement peut être encore réduite en utilisant une partie de raccordement I dont la zone de contact avec l'élément de poussée 4 n'est pas déformable selon la direction X. En effet, dans ce cas, la partie de raccordement I ne se déforme pas au contact de l'élément de poussée et la rupture de la liaison électrique entre les électrodes A et B est nette.

Selon une variante possible, l'élément de poussée peut être associé à deux seuils de déformation prédéterminés pour deux sens opposés de déplacement selon la même direction de déformation. Par exemple, l'élément de poussée peut être intercalé selon la direction X entre deux parties de raccordement de structure similaire, correspondant à deux liaisons électriques différentes entre des paires d'électrodes différentes (ayant éventuellement une électrode en commun). Lorsque l'élément de poussée se rapproche de l'une des deux parties de raccordement au-delà du seuil de déformation, la liaison électrique correspondant à ladite partie de raccordement est rompue.

Un avantage de cette variante est de permettre la détection d'événements de déformation selon des sens de déplacement relatif différents, avec des seuils prédéterminés de déformation indépendants. Lesdits seuils peuvent être identiques ou différents.

Selon une autre variante, qui peut être associée ou non à la variante précédente, un même sens de déplacement relatif selon une même direction X peut correspondre à plusieurs parties de raccordement différentes, et donc à plusieurs seuils prédéterminés de déformation différents. Le même élément de poussée 4 peut porter plusieurs parties terminales différentes qui sont configurées pour interagir avec plusieurs parties de raccordement différentes. Les différentes parties de raccordement correspondent à des liaisons électriques entre des paires d'électrodes différentes.

Dans cette dernière variante, le franchissement successif des différents seuils de déformation par l'élément de poussée permet d'évaluer de façon précise la distance de déplacement relatif de la partie portant l'élément de poussée, par rapport à la partie portant les différentes parties de raccordement.

Le capteur de l'invention est donc adaptable en fonction de l'application souhaitée : mesure de plusieurs seuils de déformation selon le même sens de mesure et/ou selon deux sens de mesure différents portés par la même direction de mesure.

### Elément de poussée et partie de raccordement des électrodes selon un exemple 1

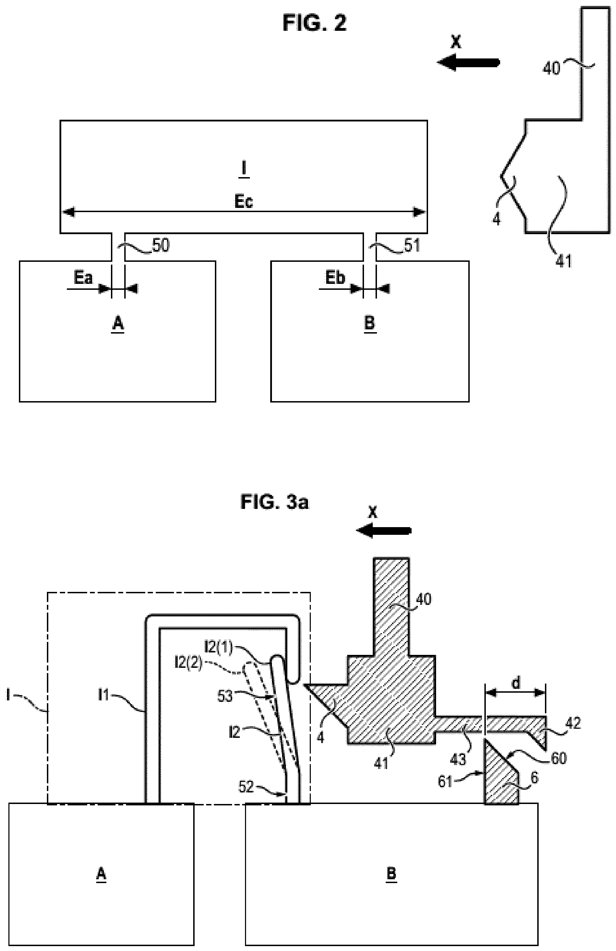

La **Figure 2** est une vue schématique rapprochée de certains éléments d'un capteur de déformation conforme à l'architecture générale ci-avant, selon un premier mode de réalisation. Ce mode de réalisation est similaire à l'exemple représenté sur les Figures 1a et 1b.

Dans ce mode, la partie de raccordement I est formée d'un bloc 54 relié à l'électrode A par un premier pont 50 et relié à l'électrode B par un deuxième pont 51. Par exemple, le bloc 54 est de forme parallélépipédique. Les ponts 50 et 51 sont en matériau conducteur. Le matériau des ponts 50 et 51 a par exemple été rendu conducteur par métallisation, par exemple par dépôt d'or. Ainsi, les ponts 50 et 51 réalisent une liaison électrique et mécanique entre la partie de raccordement I et, respectivement, l'électrode A et l'électrode B. Les électrodes A et B sont ici distantes l'une de l'autre.

Le premier pont 50 et le deuxième pont 51 sont des zones de faiblesse de la partie de raccordement, présentant une résistance à la rupture moindre par rapport au reste de la partie de raccordement. De préférence, le premier pont 50 et le deuxième pont 51 sont formés par des portions amincies de la partie de raccordement I. Dans l'exemple de la Figure 2, la partie de raccordement présente, au niveau du premier pont 50, du deuxième pont 51 et du bloc 54, des épaisseurs respectives Ea, Eb et Ec selon la direction X. Les épaisseurs Ea et Eb sont très faibles par rapport à l'épaisseur Ec, de préférence inférieures à 20% de cette dernière. Ici, chacune des épaisseurs Ea et Eb est inférieure à 10% de l'épaisseur Ec.

En alternative, un seul pont peut être réalisé entre la partie de raccordement I et la paire d'électrodes A et B. En effet, si les électrodes A et B sont suffisamment rapprochées selon la direction X, on peut réaliser un seul pont mince pour relier les deux électrodes à la partie de raccordement, tout en demeurant une zone de rupture préférentielle au niveau de ce pont mince lors de la sollicitation par l'élément de poussée 4.

L'élément de poussée 4 comprend ici une partie terminale qui s'étend vers la partie de raccordement I selon la direction X. De façon optionnelle, l'élément de poussée 4 comprend un bras 40 qui s'étend depuis la première partie mobile 2 (non représentée) du capteur vers la deuxième partie 3, ou qui est monté fixe sur ladite première partie mobile 2, le bras 40 comportant une terminaison 41 dont fait saillie la partie terminale de l'élément de poussée 4.

Dans la variante où l'élément de poussée est compris entre deux parties de raccordement, et est associé à deux seuils de déformation pour deux sens opposés de déplacement selon la même direction de déformation, l'élément de poussée peut comprendre deux parties terminales faisant saillie de la terminaison 41 dans les deux sens opposés.

Dans ce premier mode de réalisation, lorsque la première partie 2 se déplace selon la direction X par rapport à la deuxième partie 3 dans un sens de rapprochement, au-delà de la distance de déplacement L1, l'élément de poussée 4 rentre en contact avec une surface externe du bloc 54 et exerce une force de pression suffisante sur le bloc 54 pour rompre le premier pont 50 et le deuxième pont 51.

Après cette rupture (ou même en cas de rupture d'un seul des deux ponts), la liaison électrique entre les électrodes A et B passant par la partie de raccordement I est rompue.

Un avantage d'utiliser un capteur dans lequel l'événement de déformation se traduit par une rupture de liaison électrique entre les électrodes A et B est, comme indiqué ci-avant en relation aux Figures 1a et 1b, d'éviter une plage d'incertitude autour du seuil de déplacement de la partie de poussée.

La partie de raccordement I, avec les deux ponts 50 et 51, constitue ici une partie fusible mécanique. Cette partie fusible est destinée à se rompre à la suite d'un événement de déformation qui génère un déplacement de l'élément de poussée par rapport à la partie de raccordement supérieur à la distance L1.

La rupture de l'un quelconque des deux ponts 50 et 51 est irréversible. Ainsi, après un événement de déformation occasionnant un déplacement relatif au-delà de la distance de déplacement L1, la partie de raccordement I est définitivement désolidarisée des deux électrodes A et B, qui ne sont donc plus reliées électriquement entre elles.

Un avantage de l'irréversibilité de la rupture est que, pendant une période où l'alimentation électrique du capteur est momentanément coupée pendant ou après l'événement de déformation, la partie de raccordement I demeure désolidarisée des électrodes A et B. Lorsque l'alimentation électrique est récupérée, le fusible mécanique est toujours rompu. Il est donc toujours possible d'interroger le capteur et d'observer que le capteur a subi un événement de déformation.

Le capteur selon ce premier mode de réalisation est ainsi compatible avec une alimentation électrique intermittente.

### Elément de poussée et partie de raccordement des électrodes selon un exemple 2

La **Figure 3a** représente certains éléments d'un capteur de déformation conforme à l'architecture générale ci-avant, selon un deuxième mode de réalisation.

L'architecture globale du capteur est identique à ce qui précède. L'élément de poussée 4 demeure fixe par rapport à la première partie 2. Dans la position de repos, la partie de raccordement demeure fixe par rapport à la deuxième partie 3. Cependant, la partie de raccordement I de ce deuxième mode présente une structure différente de celle de la partie de raccordement du premier mode.

Ici, la partie de raccordement I comprend un élément de liaison i1 avec l'une des électrodes, par exemple l'électrode A. La partie de raccordement I comprend en outre un élément déformable i2 réalisant (en position de repos) un contact électrique entre la partie de raccordement I et l'autre des électrodes, par exemple l'électrode B. L'élément déformable i2 peut commuter entre une position ouverte représentée en trait pointillé comme i2(2) sur la Figure 3a et une position fermée représentée en trait plein comme i2(1) sur la Figure 3a. L'élément de liaison i1 est rigide et présente de préférence une rigidité supérieure à celle d'une extrémité basse de l'élément déformable i2.

Dans la position fermée de l'élément i1, une liaison électrique entre l'électrode B et l'élément de liaison i1 passe par l'élément déformable i2. L'élément de liaison i1 étant conducteur, les électrodes A et B sont reliées électriquement dans cette position fermée.

Dans la position ouverte de l'élément i1, il n'y a pas de liaison électrique passant par l'élément i2 entre l'électrode B et l'élément i1.

L'élément de poussée 4 est configuré pour solliciter l'élément déformable i2 depuis la position fermée vers la position ouverte lorsque la première partie 2 se déplace par rapport à la deuxième partie 3 selon la direction X de mesure au-delà de la distance de seuil L1. La position fermée de l'élément i2 correspond, dans ce deuxième mode, à une position de repos de la partie de raccordement I, et la position ouverte de l'élément déformable i2 correspond à une position de sollicitation de la partie de raccordement I.

Ici encore, l'élément de poussée 4 est positionné par rapport à la partie de raccordement I (notamment par rapport à l'élément déformable i2) de sorte que, pour un déplacement supérieur à la distance L1 de la première partie 2 par rapport à la deuxième partie 3 selon la direction X dans un sens de rapprochement, l'élément de poussée 4 entre en contact avec l'élément déformable i2 et le fasse basculer en position ouverte, rompant ainsi la liaison électrique entre les deux électrodes A et B.

La partie de raccordement I est agencée de sorte que l'élément déformable i2 n'est pas bloqué par un obstacle du côté opposé à celui de l'élément de poussée.

De façon avantageuse, l'élément déformable comprend une extrémité basse fixée à l'électrode B et une extrémité haute mobile par rapport à l'électrode B selon la direction X. L'extrémité haute est une extrémité libre.

Dans l'exemple de la Figure 3a, l'élément de liaison i1 est un élément rigide fixe par rapport à la deuxième partie 3. L'élément i1 comprend un crochet orienté vers le bas. L'élément déformable i2 repose, dans sa position fermée i2(1), sur l'extrémité libre du crochet, le crochet s'étendant entre l'élément déformable i2 et l'élément de poussée 4.

Ainsi, l'élément déformable i2 passe en position ouverte dès le contact, et une rupture de la liaison électrique entre les électrodes A et B est immédiatement détectée. La détection de déformation correspond précisément à la distance L1 de déplacement.

Un avantage d'utiliser un capteur dans lequel l'événement de déformation se traduit par une rupture de liaison électrique entre les électrodes A et B est, comme indiqué ci-avant en relation aux Figures 1a et 1b, d'éviter une plage d'incertitude autour du seuil de déplacement de la partie de poussée.

On notera qu'une position intermédiaire de l'élément déformable située entre la position ouverte i2(2) et la position fermée i2(1) correspond aussi à une rupture du contact électrique entre les électrodes A et B.

De façon avantageuse, l'élément déformable i2 présente une rigidité au voisinage de l'extrémité haute 53 qui est strictement supérieure à sa rigidité au voisinage de l'extrémité basse 52. L'extrémité basse 52 est flexible. L'extrémité haute 53 est, quant à elle, suffisamment rigide pour que la liaison électrique soit rompue dès le contact avec l'élément de poussée 4. Un avantage de cette configuration est que l'élément déformable i2 passe en position ouverte dès que l'élément de poussée 4 commence à appuyer sur l'extrémité haute 53 de l'élément déformable i2.

De manière très avantageuse, le capteur selon le deuxième mode de réalisation de la Figure 3a comprend en outre un système de verrouillage de l'élément déformable i2. Le système de verrouillage permet ici de verrouiller l'élément déformable i2 dans la position ouverte après un événement de déformation.

Le capteur comprend ainsi une butée 6, permettant de maintenir l'élément de poussée 4 dans une position où il sollicite l'élément déformable i2 en position ouverte, même après l'événement de déformation qui a mené l'élément déformable i2 en position ouverte.

Dans l'exemple de la Figure 3a, la butée 6 présente une forme de plot faisant saillie à partir de l'électrode B, vers l'élément de poussée 4. La butée 6 est solidaire de la deuxième partie 3 à laquelle est fixée l'électrode B. L'élément de poussée 4 est ici agencé sur une terminaison 41 d'un bras 40. Pour assurer la coopération entre l'élément de poussée 4 et la butée 6, l'élément de poussée comprend un élément de verrouillage 42 qui s'étend selon la direction X, du côté opposé à celui de l'élément déformable i2.

L'élément de verrouillage 42 est ici une pointe triangulaire placée au bout d'une perche 43. La perche 43 s'étend depuis la terminaison 41 selon la direction X dans un sens d'éloignement de l'élément déformable i2.

La butée 6 est agencée pour autoriser un déplacement relatif de l'élément de poussée 4 vers l'élément déformable i2 selon la direction X jusqu'à ce que l'élément de poussée sollicite l'élément déformable dans la position ouverte lors d'un événement de déformation : la pointe de la butée 6 est ici distante de la pointe 42 d'une distance d supérieure à L1 dans la position de repos.

La butée 6 est agencée pour empêcher un déplacement ultérieur de l'élément de poussée 4 dans un sens d'éloignement de l'élément déformable i2, après la survenance d'un événement de déformation qui engendre un contact avec l'élément déformable i2.

Autrement dit, la butée 6 empêche l'élément de poussée 4 de revenir à une position éloignée par rapport à l'élément déformable qui aurait pour effet de ré-établir la liaison électrique entre les deux électrodes A et B, après l'événement de déformation.

Ici, lorsque l'élément de poussée est déplacé vers l'élément déformable i2 d'une distance supérieure à la distance d illustrée sur la Figure 3a, la pointe 42 est d'abord mise en contact avec la butée 6, puis passe au-delà de ladite butée.

Une fois que la pointe 42 est passée au-delà de la butée 6 (à gauche de la butée sur la Figure 3a), la pointe 42 ne peut plus repasser de l'autre côté de la butée.

Ainsi, une fois la distance d franchie, l'élément déformable i2 demeure sollicité dans une position de rupture de la liaison électrique entre les électrodes A et B.

Grâce au système de verrouillage, si l'alimentation électrique du capteur est momentanément coupée pendant ou après un événement de déformation occasionnant un déplacement relatif au-delà de la distance de déplacement L1, l'élément de poussée demeure empêché par la butée 6 de retourner à sa position de repos. Ici, l'élément de poussée demeure empêché de se déplacer vers la droite. Lorsque l'alimentation électrique est récupérée, il est donc toujours possible d'observer que le capteur a subi un événement de déformation.

La coopération entre l'élément de poussée et la butée assure ainsi la compatibilité du capteur de déformation avec une alimentation électrique intermittente.

Dans l'exemple de la Figure 3a, la butée 6 comprend une surface de glissement 60 et une surface de blocage 61.

La surface de glissement 60 est orientée de sorte que lorsque l'élément de poussée 4 se déplace vers l'élément déformable i2 selon la direction X, l'élément de poussée glisse sur la surface de glissement. Ici, la surface de glissement 60 présente une pente complémentaire avec une pente de la pointe 42.

En revanche, la surface de blocage 61 est orientée de sorte que lorsque l'élément de poussée 4 se déplace ultérieurement dans un sens d'éloignement de l'élément déformable selon la direction X, l'élément de poussée 4 vient en butée contre la surface de blocage 61. Ici, la surface de blocage 61 s'étend selon une direction orthogonale à la direction X. Ainsi, la pointe 42 bute contre la surface de blocage 61 au cours d'un déplacement vers la droite depuis la gauche de la butée 6.

Cette configuration mécanique est avantageuse car elle permet de maintenir l'élément déformable i2 dans une position de rupture de la liaison électrique, sans empêcher des déplacements ultérieurs de l'élément de poussée 4 vers l'élément déformable i2.

De façon avantageuse, un circuit électronique comprenant le capteur de déformation de l'exemple de la Figure 3a comprend en outre un système de déverrouillage (non représenté ici), configuré pour solliciter l'élément de poussée ou la butée de sorte que l'élément de poussée ne soit plus limité par la butée.

Par exemple, le circuit comprend un actionneur de technologie MEMS configuré pour exercer, sur commande, une force apte à repousser l'élément de poussée 4 par rapport à la butée 6. Il peut s'agir d'un actionneur configuré pour déplacer la pointe 42 ou la perche 43 vers le haut, ce qui libère la pointe 42 et permet un déplacement de l'élément de poussée 4 vers la droite, même à la suite d'un événement de déformation.

L'actionneur fonctionne par exemple par coopération mécanique, électrostatique ou magnétique avec la pointe 42 ou la perche 43. Il s'agit typiquement d'un actionneur contrôlable électriquement, à distance.

Un tel système de déverrouillage est avantageux en association avec l'élément de verrouillage 42 et la butée 6, car il permet de déverrouiller, sur commande, l'élément de poussée pour lui permettre de retrouver son état initial avant événement de déformation.

Le capteur proposé devient, avec le système de déverrouillage, un capteur réarmable sur commande. On conserve la compatibilité du capteur avec une alimentation intermittente, le capteur n'étant réarmé que si un signal est transmis à l'actionneur du système de déverrouillage pour déverrouiller l'élément de poussée.

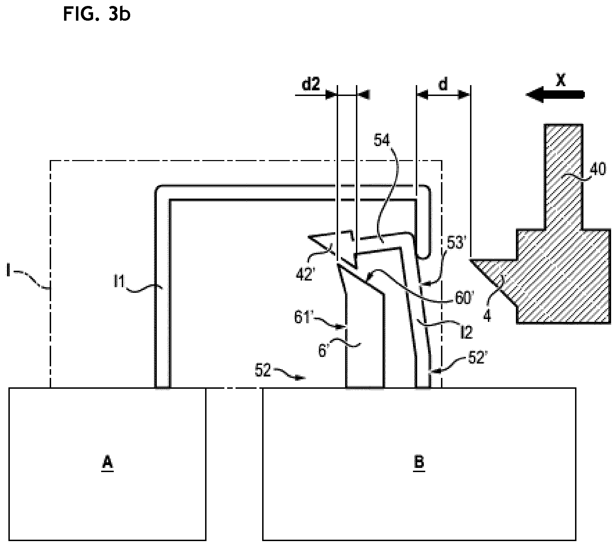

On a représenté en **Figure 3b** un capteur de déformation selon un troisième mode de réalisation. L'architecture globale du capteur de ce troisième mode est identique à celle du capteur décrit ci-avant en relation à la Figure 3a. L'élément de poussée 4 est configuré pour la détection d'un déplacement de la première partie selon la direction X sans un sens vers la gauche par rapport à la deuxième partie. L'élément de poussée 4 demeure fixe par rapport à la première partie 2. Dans la position de repos, la partie de raccordement I demeure fixe par rapport à la deuxième partie 3. De plus, la structure générale de l'élément de poussée 4 et la structure de l'élément de liaison i1 sont similaires par rapport au deuxième mode illustré en Figure 3a.

En revanche, la structure de l'élément déformable i2, agencé pour entrer en contact avec l'élément de poussée 4 en cas d'événement de déformation affectant le capteur, diffère par rapport au deuxième mode de la Figure 3a.

Dans ce troisième mode, les éléments permettant le verrouillage sont agencés directement sur l'élément déformable i2 et sur la partie de raccordement. Une butée 6' est agencée du côté opposé de l'élément déformable i2 par rapport à l'élément de poussée 4. Ainsi, lorsque l'élément de poussée 4 se déplace selon la direction X dans le sens de mesure, il pousse l'élément déformable i2 en direction de la butée 6'.

Dans ce troisième mode, le capteur ne comprend donc pas nécessairement une butée du côté opposé de l'élément de poussée 4 par rapport à l'élément déformable i2.

Dans l'exemple de la Figure 3b, un élément de verrouillage 42' est agencé directement sur l'élément déformable i2, en direction de la butée 6'. Ici, l'élément déformable i2 comprend un bras 54 qui s'étend en direction de la butée 6' et qui se termine par l'élément de verrouillage 42'. L'élément de verrouillage 42' est une pointe triangulaire placée au bout du bras 54.

De façon avantageuse, l'élément déformable i2 présente une rigidité au voisinage de l'extrémité haute 53' qui est strictement supérieure à sa rigidité au voisinage de l'extrémité basse 52', de sorte que la rupture de la liaison électrique entre les électrodes A et B intervienne dès que l'élément de poussée 4 rentre en contact mécanique avec l'extrémité haute 53' de l'élément déformable i2.

L'élément de verrouillage 42' est configuré pour être bloqué par la butée 6', une fois que l'élément de poussée 4 a franchi une distance suffisante selon la direction X pour faire passer l'élément de verrouillage 42' au-delà de la butée 6'. Cette distance suffisante est ici égale à la somme de la distance d de déplacement à partir de laquelle l'élément déformable i2 passe en position ouverte sous l'effet de la sollicitation de l'élément de poussée 4, et d'une distance supplémentaire d2 représentée sur la Figure 3b. Lorsque la butée bloque l'élément déformable i2, ce dernier ne peut plus repasser en position fermée. La liaison électrique entre les électrodes A et B reste donc rompue. Dans cette variante, il n'est pas nécessaire de fournir une autre butée sur la deuxième partie 3.

Sur la Figure 3b, la butée 6' comprend une surface de glissement 60' et une surface de blocage 61'. La surface de glissement 60' est orientée de sorte que l'élément déformable i2 glisse sur la surface de glissement lorsqu'il se rapproche de la butée 6'. Ici, la surface de glissement 60' présente une pente complémentaire avec une pente de l'élément de verrouillage 42'. En revanche, la surface de blocage 61' est orientée de sorte à bloquer l'élément déformable i2 (spécifiquement l'élément de verrouillage 42' ici) dans une position ouverte après que l'élément déformable a franchi la distance d+d2.

Le verrouillage de l'élément déformable i2 présente l'avantage de contraindre l'élément déformable i2 à demeurer en position ouverte même s'il n'y a pas d'alimentation électrique lors de l'événement de déformation ou si cette alimentation est coupée avant une interrogation du capteur. Le capteur est donc compatible avec une alimentation intermittente.

On notera qu'un circuit électronique comprenant le capteur de déformation de l'exemple de la Figure 3b peut avantageusement comporter un système de déverrouillage (non représenté ici), configuré pour solliciter l'élément déformable i2 ou la butée 6' de sorte que l'élément déformable ne soit plus bloqué par la butée.

### Mesure au sein du circuit intégrant le capteur de déformation

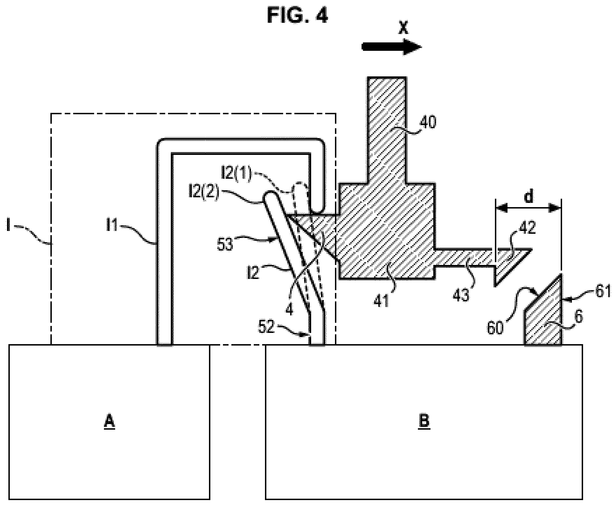

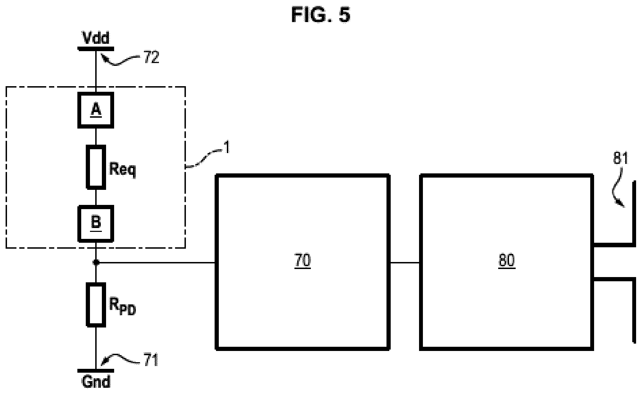

La **Figure 4** est un schéma électrique illustrant une mesure dans un circuit intégrant un capteur de déformation selon l'un quelconque des exemples précédents. Ici, une résistance équivalente entre les électrodes A et B est mesurée par l'intermédiaire d'une mesure de tension. Le dispositif de mesure de tension décrit en relation à cette Figure 4 peut aussi être utilisé avec le capteur de déformation décrit ci-après en relation à la Figure 5.

Comme il a été vu précédemment, un événement de déformation de la structure portant le capteur de déformation, avec un déplacement de la première partie 2 par rapport à la deuxième partie 3 selon la direction X au-delà d'une distance de seuil, occasionne la rupture de la liaison électrique entre les deux électrodes A et B.

Afin de traduire la rupture de ladite liaison électrique en un signal détectable en temps réel par une unité de traitement distante, le circuit présente ici un dispositif de mesure de tension électrique. Lorsque la liaison électrique entre les électrodes A et B est rompue, la tension mesurée par le dispositif de mesure de tension est modifiée.

Le dispositif de mesure de tension permet de mesurer le potentiel électrique au niveau de l'une des deux électrodes, ici l'électrode B. Dans cet exemple, le dispositif de mesure de tension est un microcontrôleur 70.

Le circuit comprend en outre un premier conducteur 71 adapté pour être porté à un potentiel électrique fixe. Il s'agit ici d'un point relié à la masse, correspondant à un potentiel nul. Le circuit comprend en outre une résistance R_{PD} disposée en série avec l'électrode B, entre le premier conducteur 71 et l'électrode B. La résistance R_{PD} présente une impédance fixe connue. Le microcontrôleur 70 fournit une mesure du potentiel à la borne de la résistance R_{PD} qui est connectée à l'électrode B.

Le circuit comprend en outre un deuxième conducteur 72 connecté à l'électrode A (qui n'est pas connecté à l'électrode B). Le deuxième conducteur 72 est porté, au cours du fonctionnement du circuit, à un potentiel fixe Vdd non nul. Le potentiel de l'électrode A en cours de fonctionnement est donc très proche du potentiel Vdd, et ledit potentiel est égal au potentiel Vdd si l'on considère que les conducteurs sont parfaits.

La mesure de tension se fonde sur un principe de pont résistif. On matérialise la liaison électrique entre les électrodes A et B qui passe par la partie de raccordement (non représentée sur la Figure 4) par une résistance équivalente R_{eq}.

De préférence, l'impédance de la résistance équivalente R_{eq} est de valeur très inférieure à l'impédance fixée de la résistance R_{PD}.

Lorsque la liaison électrique entre A et B est établie (par exemple dans une position de repos du capteur, lorsque la partie de raccordement est en position fermée), la résistance équivalente R_{eq} correspond à une impédance faible. Du fait que l'impédance de la résistance R_{eq}, lorsque la liaison électrique entre les électrodes A et B est établie, a été prise très faible par rapport à l'impédance de la résistance R_{PD}, le potentiel de l'électrode B est sensiblement égal à Vdd.

A l'inverse, lorsque la liaison électrique entre A et B est rompue (par exemple dans une position de sollicitation du capteur), la résistance équivalente R_{eq} correspond à une impédance très élevée. Le potentiel de l'électrode B est donc modifié lors de la rupture de la liaison électrique et se rapproche du potentiel du conducteur 71 au bas de la Figure 4.

Le potentiel au niveau de l'électrode B dépend ainsi du rapport entre l'impédance de la résistance R_{PD} (qui est connue) et l'impédance correspondant à la résistance équivalente R_{eq}, cette dernière étant modifiée selon l'état ouvert ou fermé de la liaison électrique entre les électrodes A et B.

Au cours du fonctionnement du capteur, le dispositif de mesure de tension (ici le microcontrôleur 70) est capable de détecter la rupture de la liaison électrique, notamment si ce dispositif de mesure de tension est interrogé par un système distant. De façon avantageuse, le circuit comprend ici un module de communication radiofréquence 80, ici un circuit UHF pour « Ultra-High Frequency », connecté à une sortie du dispositif de mesure de tension. Le module de communication 80 est également connecté à une antenne radiofréquence 81, ici une antenne UHF.

Ici, le dispositif de mesure de tension et le module de communication radiofréquence sont en-dehors du circuit électronique 1. Toutefois, en alternative, ces éléments peuvent se trouver au sein du même circuit électronique 1 que le capteur de déformation.

De préférence, une fréquence de communication de l'antenne UHF et du module de communication UHF est comprise entre 700 et 1000 Mégahertz, et est prise par exemple égale à 868 Mégahertz ou égale à 915 Megahertz (bandes ISM). La distance d'interrogation du capteur est ainsi compatible avec les utilisations usuelles de capteur de déformation.

L'utilisation d'un module de communication radiofréquence, par exemple un module UHF, connecté au dispositif de mesure de tension, est avantageuse en ce qu'elle permet de communiquer en temps réel à une unité de traitement distante (telle qu'un processeur connecté à un récepteur radiofréquence) une information selon laquelle un événement de déformation a été détecté par le capteur.

Même dans le cas où l'alimentation électrique des électrodes A et B et de la résistance R_{PD} est coupée lors d'un événement de déformation, le dispositif de mesure de tension 70 peut être interrogé ultérieurement, lorsque l'alimentation électrique est à nouveau établie. Une alimentation électrique est alors fournie aux électrodes A et B, qui sont portées à des potentiels électriques différents, ainsi qu'à la résistance R_{PD}. La valeur du potentiel mesuré au niveau de l'électrode B diffère en fonction de la position ouverte ou fermée de la partie de raccordement.

### Elément de poussée et partie de raccordement des électrodes selon un exemple 3

La **Figure 5** représente certains éléments d'un capteur de déformation conforme à l'architecture générale ci-avant, selon un quatrième mode de réalisation.

L'architecture globale du capteur est identique à ce qui précède. L'élément de poussée 4 demeure fixe par rapport à la première partie 2. Dans la position de repos, la partie de raccordement I demeure fixe par rapport à la deuxième partie 3. De plus, la structure générale de l'élément de poussée 4 et la structure de l'élément de liaison i1 sont similaires par rapport au deuxième mode illustré en Figure 3a et au troisième mode illustré en Figure 3b.

S'agissant de l'élément déformable i2, il est de forme semblable à celui du deuxième mode (et présente de préférence une extrémité basse flexible et une extrémité haute rigide). Dans ce quatrième mode, l'élément déformable i2 peut commuter entre une position fermée représentée en trait pointillé comme i2(1) et une position ouverte représentée en trait plein comme i2(2) sur la Figure 5.

De façon différente au deuxième mode, l'élément de poussée 4 est configuré pour solliciter l'élément déformable depuis la position ouverte vers la position fermée, lorsque la première partie 2 se déplace par rapport à la deuxième partie 3 selon la direction X de mesure au-delà d'une distance de seuil, dans un sens de mesure.

On notera que le sens de mesure est ici un sens d'éloignement de l'élément de poussée 4 par rapport à la partie de raccordement I, contrairement aux modes de réalisation de la Figure 2, de la Figure 3a et de la Figure 3b. L'événement de déformation mesuré ici correspond donc à un déplacement de la première partie 2 par rapport à la deuxième partie 3 dans le sens d'éloignement.

La position ouverte de l'élément déformable i2 correspond ainsi, dans ce quatrième mode, à une position de repos de la partie de raccordement I, et la position fermée de l'élément déformable i2 correspond à une position de sollicitation de la partie de raccordement I. Au repos, l'élément de poussée 4 bute contre l'élément déformable i2 de sorte à l'éloigner de l'élément de liaison i1. Au repos, l'élément déformable i2 est donc sollicité dans sa position ouverte.

Autrement dit, au repos, il n'existe pas de liaison électrique passant par l'élément déformable i2 entre les deux électrodes A et B. C'est le déplacement de l'élément de poussée 4 dans le sens d'éloignement, au-delà d'une distance de seuil - ici la distance selon la direction X entre l'élément déformable i2 et le crochet de l'élément de liaison i1 - qui donne lieu à l'établissement d'un contact électrique entre les électrodes A et B via l'élément de liaison i1 et l'élément déformable i2. De même que précédemment, la distance de seuil est préférentiellement comprise entre 5 et 500 micromètres, et encore plus préférentiellement entre 10 et 200 micromètres.

De même que pour le deuxième mode, le capteur selon le quatrième mode comprend avantageusement un système de verrouillage de l'élément déformable i2. Le système de verrouillage permet ici de verrouiller l'élément déformable i2 dans la position fermée après un événement de déformation.

Le système de verrouillage présente une fonction similaire par rapport au deuxième mode. La butée 6 autorise des déplacements ultérieurs de l'élément de poussée 4 dans le même sens que celui correspondant à l'événement de déformation détecté (ici un sens d'éloignement de l'élément déformable i2). Toutefois, le système de verrouillage empêche l'élément de poussée de se déplacer, après un événement de déformation, dans un sens contraire jusqu'à revenir en contact avec l'élément déformable i2.

Dans l'exemple de la Figure 5, le système de verrouillage du capteur comprend une butée 6 sous forme de plot, s'étendant depuis l'électrode B vers l'élément de poussée. La butée 6 comprend une surface de glissement 60 permettant à la pointe 42 de glisser sur la butée 6 lors d'un déplacement de l'élément de poussée 4 vers la droite. Contrairement à l'exemple de la Figure 3a, la surface de blocage 61 de la butée 6 est placée sur la droite de la butée. Ainsi, une fois la pointe 42 passée à droite de la butée 6, la surface de blocage 61 de la butée empêche la pointe 42 de repasser à gauche de la butée.

Après un événement de déformation occasionnant un déplacement de la pointe 42 au-delà de la distance d, l'élément de poussée 4 demeure ainsi hors de contact avec l'élément déformable i2. La liaison électrique entre les électrodes A et B passant par l'élément déformable i2 et l'élément de liaison i1 est maintenue.

Cette configuration mécanique est avantageuse car elle permet de maintenir la liaison électrique entre les électrodes A et B après un événement de déformation, sans empêcher des déplacements ultérieurs de l'élément de poussée 4 dans un sens d'éloignement de l'élément déformable i2.

La coopération entre l'élément de poussée et la butée assure donc, également ici, la compatibilité du capteur de déformation avec une alimentation électrique intermittente. On peut détecter un événement de déformation, même si cet événement se produit pendant ou après une interruption d'alimentation électrique du capteur.

De même que pour les modes décrits ci-avant en relation avec la Figure 3a et la Figure 3b, un circuit intégrant un capteur de déformation conforme à la Figure 5 peut être doté d'un système de déverrouillage (non représenté sur la figure). Le système de déverrouillage permet, par sollicitation de l'élément de poussée ou de la butée, de libérer l'élément de poussée.

On peut par exemple prévoir un actionneur configuré pour solliciter vers le haut, sur commande, la perche 43 ou la pointe 42. Après actionnement, la pointe 42 n'est plus en contact avec la butée 6, ce qui permet à l'élément de poussée 4 de se déplacer vers la gauche.

Le capteur proposé devient ainsi, par l'intermédiaire du système de déverrouillage, un capteur réarmable sur commande.

Dans les exemples des Figures 3a, 3b et 5, le système de déverrouillage est par exemple configuré pour être activé en réponse à un signal de réarmement reçu depuis un dispositif distant tel qu'un serveur. Par exemple, le capteur est réarmé dès lors que le dispositif distant a enregistré l'information selon laquelle le capteur a détecté un événement de déformation. Le signal de réarmement peut par exemple être reçu par l'intermédiaire du circuit RFID 80. En alternative ou en combinaison, le système de déverrouillage est configuré pour réarmer le capteur à intervalles réguliers.

## Revendications

1. Capteur de déformation de type MEMS, le capteur étant adapté pour mesurer un déplacement relatif entre deux zones d'une structure, le capteur comprenant :
- une première partie (2) et une deuxième partie (3) mobiles l'une par rapport à l'autre selon une direction de mesure (X),
- un élément de poussée (4) monté fixe par rapport à la première partie (2),
- une première électrode (A) et une deuxième électrode (B) adaptées pour être portées à des potentiels électriques différents, chaque électrode étant montée fixe par rapport à la deuxième partie (3),
- une partie de raccordement (I) formant une liaison électrique entre la première électrode (A) et la deuxième électrode (B),
le capteur étant **caractérisé en ce que** l'élément de poussée (4) est configuré pour exercer une sollicitation sur la partie de raccordement (I) lorsque la première partie (2) se déplace par rapport à la deuxième partie (3) selon la direction de mesure (X) au-delà d'une distance prédéterminée, la liaison électrique étant rompue sous l'effet de la sollicitation.

2. Capteur selon la revendication 1, dans lequel l'élément de poussée (4) est configuré pour exercer la sollicitation sur la partie de raccordement (I) lorsque la première partie (2) se déplace par rapport à la deuxième partie (3) selon un premier sens, et pour ne pas exercer de sollicitation sur la partie de raccordement (I) lorsque la première partie (2) se déplace par rapport à la deuxième partie (3) dans un deuxième sens, opposé au premier sens, selon la direction de mesure (X).

3. Capteur selon l'une quelconque des revendications 1 ou 2, dans lequel la partie de raccordement (I) comprend un premier pont (50) et un deuxième pont (51), le premier pont et le deuxième pont étant fixés respectivement à la première électrode (A) et à la deuxième électrode (B), la sollicitation de l'élément de poussée (4) sur la partie de raccordement ayant pour effet de rompre le premier pont et le deuxième pont.

4. Capteur selon la revendication 3, dans lequel le premier pont (50) et le deuxième pont (51) sont formés par des portions amincies de la partie de raccordement (I).

5. Capteur selon l'une quelconque des revendications 1 ou 2, dans lequel la partie de raccordement (I) comprend un élément déformable (i2), l'élément déformable (i2) étant propre à être déformé entre une configuration ouverte et une configuration fermée, la partie de raccordement reliant électriquement la première électrode (A) et la deuxième électrode (B) entre elles lorsque l'élément déformable est dans la configuration fermée,
L'élément de poussée (4) étant propre à solliciter l'élément déformable (i2) depuis la configuration ouverte vers la configuration fermée lorsque la première partie (2) se déplace par rapport à la deuxième partie (3) selon la direction de mesure (X).

6. Capteur selon la revendication 5, dans lequel l'élément déformable (i2) comporte une première extrémité (52) fixée à la deuxième électrode (B) et une deuxième extrémité (53) propre à être déplacée par rapport à la deuxième électrode (B) lors d'une déformation de l'élément déformable (i2).

7. Capteur selon la revendication 6, dans lequel l'élément déformable (i2) présente une première rigidité au voisinage de la première extrémité et présente une deuxième rigidité au voisinage de la deuxième extrémité, la première rigidité étant strictement inférieure à la deuxième rigidité.

8. Capteur selon l'une quelconque des revendications 5 à 7, le capteur comprenant une butée (6) agencée pour autoriser un déplacement relatif de l'élément de poussée (4) dans un premier sens vers l'élément déformable (i2) jusqu'à ce que l'élément de poussée (4) sollicite l'élément déformable, et pour empêcher un déplacement ultérieur de l'élément de poussée (4) dans un deuxième sens, opposé au premier sens.

9. Capteur selon la revendication 8, comprenant un bras (40) comportant une terminaison (41), l'élément de poussée (4) comprenant un élément de verrouillage (42) s'étendant depuis la terminaison (41) selon une direction sensiblement parallèle à la direction de mesure (X), l'élément de verrouillage étant configuré pour coopérer avec la butée (6).

10. Capteur selon l'une quelconque des revendications 8 ou 9, dans lequel la butée (6) fait saillie à partir de la deuxième électrode (B) vers l'élément de poussée (4).

11. Capteur selon l'une quelconque des revendications 8 à 10, dans lequel la butée (6) comprend une surface de glissement et une surface de blocage, la surface de glissement étant orientée de sorte que lorsque l'élément de poussée (4) se déplace dans un premier sens, vers l'élément déformable (i2), l'élément de poussée glisse sur la surface de glissement, et la surface de blocage étant orientée de sorte que lorsque l'élément de poussée (4) se déplace ultérieurement dans un deuxième sens, opposé au premier sens, en s'écartant de l'élément déformable (i2), l'élément de poussée (4) vient en butée contre la surface de blocage.

12. Capteur selon l'une quelconque des revendications 1 à 11, dans lequel la deuxième partie (3) comprend un substrat de type silicium sur isolant, aussi dit SOI, la première électrode (A) et la deuxième électrode (B) étant portées par le substrat.

13. Circuit électronique comportant un capteur de déformation selon l'une quelconque des revendications 1 à 12.

14. Circuit électronique selon la revendication 13, comprenant en outre :
- un conducteur (71) configuré pour être porté à un potentiel fixe,
- une résistance (R_{PD}) comprenant une première borne et une deuxième borne, la première borne étant connectée au conducteur (71), la deuxième borne étant connectée à la première électrode (A) du capteur de déformation ou à la deuxième électrode (B) du capteur de déformation,
- un dispositif (70) de mesure de tension, ledit dispositif étant configuré pour fournir une mesure du potentiel de la deuxième borne.

15. Circuit électronique selon l'une quelconque des revendications 13 ou 14, comportant un capteur de déformation conforme à l'une quelconque des revendications 8 à 11, le circuit comprenant en outre un système de déverrouillage qui comprend un actionneur configuré pour exercer, sur commande, une force apte à repousser l'élément de poussée (4) par rapport à la butée (6), de préférence une force électrique ou magnétique.

## Patentansprüche

1. Verformungssensor vom Typ MEMS, wobei der Sensor zum Messen einer relativen Verlagerung zwischen zwei Zonen einer Struktur geeignet ist, wobei der Sensor umfasst:
- einen ersten Teil (2) und einen zweiten Teil (3), die im Verhältnis zueinander in einer Messrichtung (X) beweglich sind,
- ein Schubelement (4), das im Verhältnis zum ersten Teil (2) fest angebracht ist,
- eine erste Elektrode (A) und eine zweite Elektrode (B), die geeignet sind, auf unterschiedliche elektrische Potentiale gebracht zu werden, wobei jede Elektrode im Verhältnis zum zweiten Teil (3) fest angebracht ist,
- einen Anschlussteil (I), der eine elektrische Verbindung zwischen der ersten Elektrode (A) und der zweiten Elektrode (B) bildet,
wobei der Sensor **dadurch gekennzeichnet ist, dass** das Schubelement (4) ausgelegt ist, um auf den Anschlussteil (I) eine Kraft auszuüben, wenn sich der erste Teil (2) im Verhältnis zum zweiten Teil (3) in der Messrichtung (X) jenseits einer vorher festgelegten Distanz verlagert, wobei die elektrische Verbindung unter der Wirkung der Kraft unterbrochen wird.

2. Sensor nach Anspruch 1, wobei das Schubelement (4) ausgelegt ist, um die Kraft auf den Anschlussteil (I) auszuüben, wenn sich der erste Teil (2) im Verhältnis zum zweiten Teil (3) in einer ersten Richtung verlagert, und um keine Kraft auf den Anschlussteil (I) auszuüben, wenn sich der erste Teil (2) im Verhältnis zum zweiten Teil (3) in einer zweiten Richtung entgegengesetzt zur ersten Richtung in der Messrichtung (X) verlagert.

3. Sensor nach einem der Ansprüche 1 oder 2, wobei der Anschlussteil (I) eine erste Brücke (50) und eine zweite Brücke (51) umfasst, wobei die erste Brücke und die zweite Brücke jeweils an der ersten Elektrode (A) und an der zweiten Elektrode (B) befestigt sind, wobei die Kraft des Schubelements (4) auf den Anschlussteil einen Bruch der ersten Brücke und der zweiten Brücke bewirkt.

4. Sensor nach Anspruch 3, wobei die erste Brücke (50) und die zweite Brücke (51) von verschlankten Abschnitten des Anschlussteils (I) gebildet sind.

5. Sensor nach einem der Ansprüche 1 oder 2, wobei der Anschlussteil (I) ein verformbares Element (i2) umfasst, wobei das verformbare Element (i2) imstande ist, zwischen einer geöffneten Konfiguration und einer geschlossenen Konfiguration verformt zu sein, wobei der Anschlussteil die erste Elektrode (A) und die zweite Elektrode (B) miteinander elektrisch verbindet, wenn das verformbare Element in der geschlossenen Konfiguration ist,
wobei das Schubelement (4) imstande ist, auf das verformbare Element (i2) aus der geöffneten Konfiguration in die geschlossene Konfiguration zu beanspruchen, wenn sich der erste Teil (2) im Verhältnis zum zweiten Teil (3) in der Messrichtung (X) verlagert.

6. Sensor nach Anspruch 5, wobei das verformbare Element (i2) ein erstes Ende (52) aufweist, das an der zweiten Elektrode (B) befestigt ist, und ein zweites Ende (53), das imstande ist, im Verhältnis zur zweiten Elektrode (B) bei einer Verformung des verformbaren Elements (i2) verlagert zu werden.

7. Sensor nach Anspruch 6, wobei das verformbare Element (i2) eine erste Festigkeit in der Nähe des ersten Endes aufweist und eine zweite Festigkeit in der Nähe des zweiten Endes aufweist, wobei die erste Festigkeit strikt kleiner als die zweite Festigkeit ist.

8. Sensor nach einem der Ansprüche 5 bis 7, wobei der Sensor einen Anschlag (6) umfasst, der eingerichtet ist, um eine relative Verlagerung des Schubelements (4) in einer ersten Richtung zum verformbaren Element (i2) zu gestatten, bis das Schubelement (4) eine Kraft auf das verformbare Element ausübt, und um eine spätere Verlagerung des Schubelements (4) in einer zweiten Richtung entgegengesetzt zur ersten Richtung zu verhindern.

9. Sensor nach Anspruch 8, umfassend einen Arm (40), der einen Abschluss (41) aufweist, wobei das Schubelement (4) ein Verriegelungselement (42) umfasst, das sich ab dem Abschluss (41) in einer Richtung erstreckt, die etwa parallel zur Messrichtung (X) ist, wobei das Verriegelungselement ausgelegt ist, um mit dem Anschlag (6) zusammenzuwirken.

10. Sensor nach einem der Ansprüche 8 oder 9, wobei der Anschlag (6) ausgehend von der zweiten Elektrode (B) zum Schubelement (4) hervorsteht.

11. Sensor nach einem der Ansprüche 8 bis 10, wobei der Anschlag (6) eine Gleitoberfläche und eine Arretieroberfläche umfasst, wobei die Gleitoberfläche derart ausgerichtet ist, dass, wenn sich das Schubelement (4) in einer ersten Richtung zum verformbaren Element (i2) verlagert, das Schubelement über die Gleitoberfläche gleitet, und die Arretieroberfläche derart ausgerichtet ist, dass, wenn sich das Schubelement (4) später in einer zweiten Richtung entgegengesetzt zur ersten Richtung verlagert, indem es sich vom verformbaren Element (i2) entfernt, das Schubelement (4) an der Arretieroberfläche in Anschlag kommt.

12. Sensor nach einem der Ansprüche 1 bis 11, wobei der zweite Teil (3) ein Substrat vom Typ Silizium auf Isolator umfasst, auch als SOI bezeichnet, wobei die erste Elektrode (A) und die zweite Elektrode (B) von dem Substrat getragen werden.

13. Elektronischer Schaltkreis, der einen Verformungssensor nach einem der Ansprüche 1 bis 12 aufweist.

14. Elektronischer Schaltkreis nach Anspruch 13, der ferner umfasst:
- einen Leiter (71), der ausgelegt ist, um auf ein festes Potential gebracht zu werden,
- einen Widerstand (R_{PD}), der eine erste Klemme und eine zweite Klemme umfasst, wobei die erste Klemme mit dem Leiter (71) verbunden ist, wobei die zweite Klemme mit der ersten Elektrode (A) des Verformungssensors oder mit der zweiten Elektrode (B) des Verformungssensors verbunden ist,
- eine Spannungsmessvorrichtung (70), wobei die Vorrichtung ausgelegt ist, um eine Messung des Potentials der zweiten Klemme bereitzustellen.

15. Elektronischer Schaltkreis nach einem der Ansprüche 13 oder 14, der einen Verformungssensor nach einem der Ansprüche 8 bis 11 aufweist, wobei der Schaltkreis ferner ein Entriegelungssystem umfasst, das einen Aktuator umfasst, der ausgelegt ist, um auf Befehl eine Kraft, vorzugsweise eine elektrische oder magnetische Kraft, auszuüben, die imstande ist, das Schubelement (4) im Verhältnis zum Anschlag (6) zurückzuschieben.

## Claims

1. A MEMS type deformation sensor, the sensor being adapted to measure a relative displacement between two areas of a structure, the sensor comprising:
- a first part (2) and a second part (3) movable relative to each other along an axis of measurement (X),
- a pushing element (4) fixedly mounted relative to the first part (2),
- a first electrode (A) and a second electrode (B) adapted to be brought to different electric potentials, each electrode being fixedly mounted relative to the second part (3),
- a junction part (I) forming an electrical connection between the first electrode (A) and the second electrode (B),
the sensor being **characterized in that** the pushing element (4) is configured to exert a load on the junction part (I) when the first part (2) moves relative to the second part (3) along the axis of measurement (X) beyond a predetermined distance, the electrical connection being broken under the effect of the load.

2. The sensor according to claim 1, wherein the pushing element (4) is configured to exert the load on the junction part (I) when the first part (2) moves relative to the second part (3) along a first direction, and not to exert any load on the junction part (I) when the first part (2) moves relative to the second part (3) in a second direction, opposite to the first direction, along the axis of measurement (X).

3. The sensor according to any one of claim 1 or 2, wherein the junction part (I) comprises a first bridge (50) and a second bridge (51), the first bridge and the second bridge being respectively fixed to the first electrode (A) and to the second electrode (B), the load of the pushing element (4) on the junction part having the effect of breaking the first bridge and the second bridge.

4. The sensor according to claim 3, wherein the first bridge (50) and the second bridge (51) are formed by thinned portions of the junction part (I).

5. The sensor according to any one of claim 1 or 2, wherein the junction part (I) comprises a deformable element (i2), the deformable element (i2) being designed to be deformed between an open configuration and a closed configuration, the junction part electrically linking together the first electrode (A) and the second electrode (B) when the deformable element is in the closed configuration,
the pushing element (4) being designed to load the deformable element (i2) from the open configuration towards the closed configuration when the first part (2) moves relative to the second part (3) along the direction of measurement (X).

6. The sensor according to claim 5, wherein the deformable element (i2) includes a first end (52) fixed to the second electrode (B) and a second end (53) designed to be moved relative to the second electrode (B) during a deformation of the deformable element (i2).

7. The sensor according to claim 6, wherein the deformable element (i2) has a first rigidity in the vicinity of the first end and has a second rigidity in the vicinity of the second end, the first rigidity being strictly lower than the second rigidity.

8. The sensor according to any one of claims 5 to 7, the sensor comprising an abutment (6) arranged to authorize a relative displacement of the pushing element (4) in a first direction towards the deformable element (i2) until the pushing element (4) loads the deformable element, and to prevent a subsequent displacement of the pushing element (4) in a second direction, opposite to the first way.

9. The sensor according to claim 8, comprising an arm (40) including a termination (41), the pushing element (4) comprising a locking element (42) extending from the termination (41) along an axis substantially parallel to the axis of measurement (X), the locking element being configured to cooperate with the abutment (6) .

10. The sensor according to any one of claim 8 or 9, wherein the abutment (6) protrudes from the second electrode (B) towards the pushing element (4).

11. The sensor according to any one of claims 8 to 10, wherein the abutment (6) comprises a sliding surface and a blocking surface, the sliding surface being oriented so that when the pushing element (4) moves in a first direction, towards the deformable element (i2), the pushing element slides on the sliding surface, and the blocking surface being oriented so that when the pushing element (4) subsequently moves in a second direction, opposite to the first way, while moving away from the deformable element (i2), the pushing element (4) comes into abutment against the blocking surface.

12. The sensor according to any one of claims 1 to 11, wherein the second part (3) comprises a silicon-on-insulator type substrate, also called SOI, the first electrode (A) and the second electrode (B) being carried by the substrate.

13. An electronic circuit including a deformation sensor according to any one of claims 1 to 12.

14. The electronic circuit according to claim 13, further comprising:
- a conductor (71) configured to be brought to a fixed potential,
- a resistance (R_{PD}) comprising a first terminal and a second terminal, the first terminal being connected to the conductor (71), the second terminal being connected to the first electrode (A) of the deformation sensor or to the second electrode (B) of the deformation sensor,
- a voltage measuring device (70), said device being configured to provide a measurement of the potential of the second terminal.

15. The electronic circuit according to any one of claim 13 or 14, including a deformation sensor in accordance with any one of claims 8 to 11, the circuit further comprising an unlocking system which comprises an actuator configured to exert, on command, a force able to push back the pushing element (4) relative to the abutment (6), preferably an electric or magnetic force.
